# EUROPÄISCHE PATENTSCHRIFT

(11) **EP 0 717 886 B1**
(45) Veröffentlichungstag und Bekanntmachung des Hinweises auf die Patenterteilung: **07.05.1997**
(21) Anmeldenummer: 93918961.9
(22) Anmeldetag: 08.09.1993
(51) Int. Cl.: H02H 9/02, H03K 17/08

(54) **STROMBEGRENZER**
CURRENT LIMITING DEVICE
LIMITEUR DE COURANT

(43) Veröffentlichungstag der Anmeldung: 26.06.1996
(73) Patentinhaber: SIEMENS AKTIENGESELLSCHAFT, 80333 München (DE)
(72) Erfinder: RÖSCH, Helmut, D-93161 Sinzing (DE); ZIERHUT, Hermann, D-93073 Neutraubling (DE)
(86) Internationale Anmeldenummer: DE9300824
(87) Internationale Veröffentlichungsnummer: WO9507570

(56) Entgegenhaltungen:
- EP-A- 0 142 128
- WO-A-93/11608
- DE-A- 3 634 070

## Beschreibung

Die Erfindung bezieht sich auf einen Strombegrenzer zum Begrenzen von Überströmen mittels eines Halbleiterelements mit mindestens einem steuerbaren Halbleiter, der Kennlinien nach Art eines Feldeffekttransistors (FET) aufweist.

Bei Schutzschaltgeraten, wie Leistungsschaltern, Motorschutzschaltern oder Leitungsschutzschaltern, allgemein bei Selbstschaltern, ist es wünschenswert, auftretende Überlastströme, insbesondere Kurzschlußströme, rasch zu erfassen und sie auf möglichst kleine Werte zu begrenzen und schließlich abzuschalten. Bei im wesentlichen mechanischen Selbstschaltern, beispielsweise bei Leitungsschutzschaltern, verwendet man sogenannte Schnellauslöser, bei denen sowohl der Magnetkreis optimal ausgelegt ist als auch ein Magnetanker, oft ein Tauchanker, das Kontaktsystem schnell und kräftig aufschlägt. Trotzdem hat man in der Praxis noch keine kürzeren Kontaktöffnungszeiten als etwa eine Millisekunde erreicht. Der Kurzschlußstrom steigt hierbei bis zur Kontaktöffnung ungehindert an. Erst nach der Kontaktöffnung entsteht ein Lichtbogen, der rasch in eine Lichtbogenkammer geführt wird und an Löschblechen bei Aufteilung des Lichtbogens gekühlt wird. Durch die hierbei hohen Lichtbogenspannungen wird der Kurzschlußstrom begrenzt und schließlich abgeschaltet.

Bei bekannten Selbstschaltern erreicht man bei einem prospektiven Kurzschlußstrom von 6 kA, cos Phi = 0,6 und Psi = 60° kaum kleinere Stromzeitwerte als :

Schaltstrom von 4000 A Anstiegszeit bis zum Scheitelwert von 4 Millisekunden und einem Integral des Stromquadrats über die Zeit von 30.000 A²s.

Mitunter wurde schon vorgeschlagen, für die Strombegrenzung in Schutzschaltgeraten Halbleiter einzusetzen. Dies wird in der Praxis durch verschiedenartige Gegebenheiten erschwert oder verhindert:
- Halbleiterelemente weisen in der Regel eine unzureichende strombegrenzende Wirkung auf und eine zu geringe zulassige Energieaufnahme.
- Halbleiterlemente haben in der Regel im Normalbetrieb einen Durchlaßwiderstand oberhalb von 10 Milliohm bei 16 A.
- In der Regel weisen Halbleiterlemente auch eine zu geringe Spannungsfestigkeit auf.

Der Erfindung liegt die Aufgabe zugrunde, einen Strombegrenzer aus einem Halbleiterelement mit zumindest einem steuerbaren Halbleiter zu entwickeln, bei den die bisher üblichen Nachteile der Halbleiterschaltungen bis auf ein technisch brauchbares Ausmaß verringert werden.

Die Lösung der geschilderten Aufgabe erfolgt nach der Erfindung durch einen Strombegrenzer nach Patentanspruch 1. Hierbei wird die zur Ansteuerung des Halbleiterelements erforderliche Steuerspannung aus zumindest einem Teil des Laststrom gewonnen, der das Halbleiterlement durchfließt. Die Steuerspannung kann auch aus zumindest einem Teil des Spannungsfalls am Halbleiterelement gewonnen werden. Man kann die Steuerspannung auch aus beiden Vorkehrungen kombiniert erzielen.

Ein bekannter Leistungsschalter (WO 93/11608) wirkt als Strombegrenzer zum Begrenzen von Überströmen mittels eines Halbleiterelements mit mindestens einem steuerbaren Halbleiter mit Elektronenquelle (Source), Elektronensammler (Drain) und den Elektronenfluß steuernder Steuerelektrode (Gate), der Kennlinien eines Feldeffekttransistors (FET) aufweist, wobei der Laststrom das Halbleiterelement durchfließt und wobei bei Wechselspannung zwei FET's antiseriell geschaltet sind. Hierbei ist eine externe Steuerspannung vorgesehen.

Das Mittel zur Ansteuerung aus Spannungsfall kann erfindungsgemäß jeweils eine an Drain und Gate des Halbleiters angeschlossene Ansteuerschaltung sein. Als Mittel zur Ansteuerung aus Laststrom eignet sich jeweils ein im Laststrom liegender Strom-Spannungswandler.

Die Ansteuerschaltung bei Gleichspannung kann im einfachsten Fall aus einem Widerstand bestehen, der zwischen Drain-Anschluß und Gate-Anschluß eines FETs angeschlossen ist. Eine Ansteuerschaltung bei Wechselspannung kann in einfachster Weise so aufgebaut sein, daß die Drain-Anschlüsse zweier antiseriell geschalteter FETs über jeweils ein Ventil und über einen Widerstand mit den Gate-Anschlüssen verbunden sind. Eine derartige Schaltung eignet sich in Verbindung mit FETs des Enhancement-Typs, also mit selbstsperrenden FETs, die einen n-Kanal aufweisen, als Anlaufschaltung, die es dem Strombegrenzer ermöglicht, sich in den Betriebszustand hochzufahren. Eine derartige Anlaufschaltung ist nicht erforderlich, wenn man selbstleitende FETs mit n-Kanal, also des Depletion-Typs einsetzt und insbesondere eignen sich Depletion MOSFETs.

Als Ansteuerschaltung bei Gleichspannung eignet sich auch eine Konstantstromquelle, die zwischen Drain-Anschluß und Gate-Anschluß angeschlossen wird. Eine Ansteuerschaltung bei Wechselspannung kann vorteilhaft so aufgebaut werden, daß die Drain-Anschlüsse zweier antiseriell geschalteter FETs über jeweils ein Ventil und über eine Konstantstromquelle mit den Gate-Anschlüssen verbunden sind.

Als Stromspannungswandler zur Ansteuerung aus Laststrom eignet sich insbesondere ein Übertrager, an dessen Sekundärwicklung ein in beiden Polaritätsrichtungen spannungsbegrenzendes Element, insbesondere zwei antiseriell geschaltete Zenerdioden, angeschlossen ist, bzw. sind, dessen Ausgänge über eine Gleichrichterschaltung mit den Gate-Anschlüssen verbunden sind. Als antiseriell geschaltete Zenerdioden werden hier alle Elemente zusammengefaßt, die die Wirkung einer spannungsbegrenzenden Zenerdiode aufweisen. Bei Wechselspannung werden dann Kennlinien im ersten und dritten Quadranten eines Diagramms mit dem Drain-Source-Strom auf der Ordinate über der Drain-Source-Spannung auf der Abzisse auf einen gewünschten Drain-Source-Strom begrenzt.

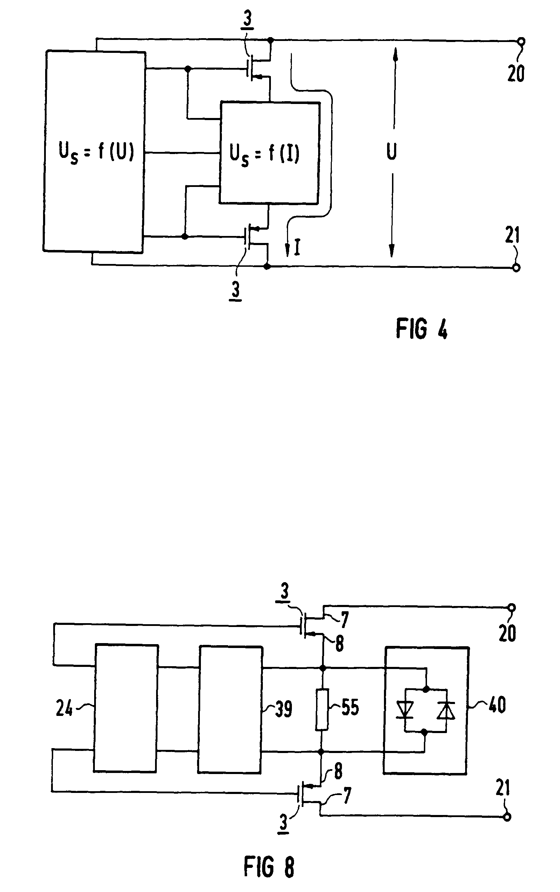

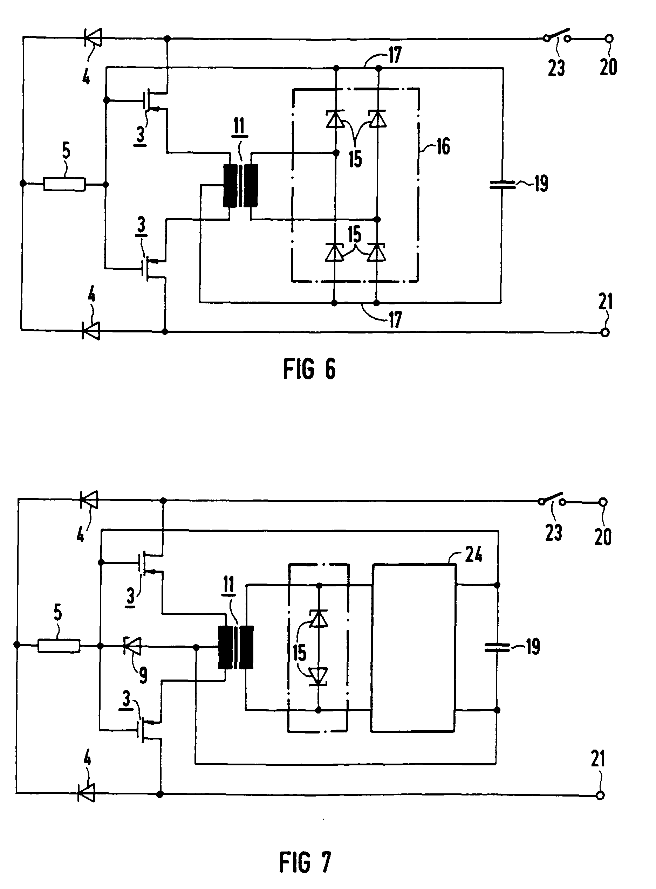

Der Einsatz eines überträgers zwischen zwei antiseriell geschalteten FETs als Induktivität zur Begrenzung von Kurzschlußstrom ist Gegenstand einer eigenen europäischen Patentanmeldung mit älteren Zeitrang (Aktenzeichen 92 116 358.0, Figur 4, Figur 7). Hierbei dient der Übertrager zugleich zum Einbinden einer extern anzulegenden Steuerspannung.

Beim Strombegrenzer mit einem Übertrager in der Ausführung als Strom-Spannungswandler gewinnt man die Ansteuerspannung aus dem Laststrom, also intern. Man erzielt weiter den Vorteil, daß der Laststrom in einer niederohmigen Primärwicklung mit wenigen Windungen geführt werden kann und daß sich die Sekundärseite mit vielen Windungen hochohmig ausführen läßt, um aus den Laststrom eine Spannung für die Ansteuerung abzuleiten. Durch das spannungsbegrenzende Element wird hierbei sichergestellt, daß der Drain-Source-Strom auf einer Kurve mit dem entsprechenden Parameter der Gate-Source-Spannung verlustarm begrenzt wird.

Es ist vorteilhaft, einen Übertrager an einer Sekundärwicklung eine Gleichrichterschaltung anzuschließen und einen Kondensator zwischen Gleichspannungspotentialpunkten für die Ansteuerspannung einzuschalten, im einzelnen nach Anspruch 7. Der Kondensator kann gegebenenfalls aus der Gate-Source-Kapazität des FET gebildet werden, wenn diese eine ausreichende Größe aufweist. Es ist bei Einsatz spannungsbegrenzender Element vorteilhaft, diese aus Zenerdioden in Brückenschaltung anzuordnen, im einzelnen nach Anspruch 8.

Die Gleichrichterschaltung kann vorteilhaft auch als Spannungsvervielfacherschaltung nach Anspruch 9 ausgeführt werden.

Schließlich kann der Strom-Spannungswandler nach Anspruch 10 ein Zerhacker mit nachgeschaltetem Spannungsvervielfacher sein, wodurch man ohne einem Übertrager die Ansteuerspannung aus dem Laststrom gewinnen kann.

Die erfindungsgemäßen Lösungen und ihre Vorteile lassen sich weiter fördern, wenn die FETs aus Siliziumkarbid, SiC, angefertigt sind. Hierbei unterstützen sich wechselseitig die an sich bekannten Vorteile eines FETs aus Siliziumkarbid und die eines Strombegrenzers nach einem der Patentansprüche.

Eine Strombegrenzung in Verbindung mit Mitteln zur Ansteuerung aus Spannungsfall oder aus Laststrom läßt sich allgemein durch eine Schaltung nach Anspruch 12 erzielen.

Zusätzlich zur internen Gewinnung der Ansteuerspannung ist es auch möglich, nach Anspruch 13 am Halbleiterelement eine Ansteuereinrichtung zur zusätzlichen externen Ansteuerung vorzusehen. Es können dann von außen korrigierende Steuerspannungen angelegt werden. Es ist auch möglich, durch eine Ansteuerung von außen nach Anspruch 14 bei Erhalt eines vorgesehenen Eingangssignals eine das Halbleiterelement sperrende Spannung zu generieren. Ein derartiger Strombegrenzer wirkt dann als Ausschalter. Ein derartiger Strombegrenzer läßt sich allgemein mit Halbleitern aufbauen, die die geschilderten besonderen Eigenschaften aufweisen. Der Strombegrenzer kann als integrierte Schaltung auf einen Chip, mit diskreten Bauelementen oder in einem Mischaufbau ausgeführt werden.

Es kann für bestimmte Anwendungsfälle vorteilhaft sein, in Reihe zum Halbleiterelement zumindest einen mechanischen Schaltkontakt nach Anspruch 15 anzuordnen. Es genügt dann ein verhältnismäßig einfacher Schaltkontakt ohne besondere Löschmittel, da der Stromanstieg durch den Strombegrenzer begrenzt wird. Andererseits schützt der Schaltkontakt, wenn er geöffnet wurde, den Strombegrenzer gegen Langzeitüberlastung. Dieses Zusammenspiel ermöglicht vorteilhafte Konstuktionen.

Ein Schutzschalter in Selbstschalterausführung mit zwei antiseriell angeordneten FETs und einem mechanischen Schaltkontakt ist an sich bekannt (PCT/EP 92/02678). Bei diesem älteren, als Leistungsschalter ausgebildeten Schutzschalter ist eine Einheit aus Relais und Schaltkontakten zu zwei antiseriell verbundeten FETs parallel geschaltet. Die Schaltkontakte sind auch dort zu der Zusammenschaltung der FETs in Serie angeordnet. Der Innenwiderstand des Halbleiterelements weist jedoch bei einer bestimmten Steuerspannung einen niedrigen Wert auf, und mit steigender Spannung an den Arbeitselektroden steigt der Innenwiderstand sprunghaft an, so daß das Auslöseglied des Relais mit Spannung versorgt wird und den Abschaltvorgang einleiten kann.

Die Wirkungsweise des Strombegrenzers mit einem in Reihe angeordneten mechanischen Schaltkontakt unterscheidet sich hiervon grundlegend. Der Schaltkontakt kann nach Anspruch 16 direkt oder indirekt über einen Kraftspeicher in Eingriffverbindung mit einem Magnetsystem stehen, das in Abhängigkeit vom Strombegrenzer den Schaltkontakt Öffnet.

Ein besonders günstiges Zusammenwirken von Halbleiterelement und Magnetsystem für den Schaltkontakt erzielt man durch einen Aufbau nach Anspruch 17. Das Magnetsystem weist eine zur Sekundärwicklung vergleichsweise niederohmige Primärwicklung auf und bildet einerseits den Übertrager zur Gewinnung einer Steuerspannung aus Laststrom. Andererseits bildet das Magnetsystem mit seiner niederohmigen Primärwicklung zugleich die Erregerwicklung für dasjenige Magnetsystem, dessen Anker in Wirkverbindung mit dem Schaltkontakt steht. Man erzielt hierbei eine Mehrfachnutzung von Konstruktionselementen in kombinierter Anordnung. Insbesondere kann der Ankerluftspalt durch ein Hilfsjoch nach Anspruch 18 überbrückt werden, so daß ein gut geschlossener magnetischer Kreis für den Strom-Spannungswandler entsteht und das derart bemessen ist, daß es bereits bei vergleichsweise kleinen Strömen in Sättigung geht. Hierdurch bleibt sowohl die Funktion des Ankers als auch die des magnetischen Kreises für den Strom-Spannungswandler in der Praxis unbeeinträchtigt.

Hierzu ist der Arbeitsluftspalt also durch ein Hilfsjoch überbrückt, das derart bemessen ist, daß es in magnetische Sättigung bereits bei Strömen geht, die kleiner als der gewünschte Ansprechstrom für den Magnetanker ist.

Das Halbleiterelement kann allgemein in einem Selbstschalter, wie beispielsweise einem Leistungsschalter, einem Leitungsschutzschalter oder in einem Motorschutzschalter oder anderen Schutzeinrichtungen, als strombegrenzendes Teil mit der Funktion eines sogenannten Limiters eingesetzt werden. Verständlicherweise können das Halbleiterelement und der mechanische Schaltkontakt jeweils Teil räumlich gesonderter Schalteinrichtungen sein.

Die Erfindung soll nun anhand von in der Zeichnung grob schematisch wiedergegebenen Ausführungsbeispielen näher erläutert werden:
- FIG 1: ist ein erstes, vereinfachtes Ausführungsbeispiel für den Strombegrenzer, wobei die Ansteuerung, bzw. die Steuerspannung aus Spannungsfall am Halbleiterelement gewonnen wird.
- FIG 2: veranschaulicht einen Strombegrenzer, dessen Steuerspannung aus dem Laststrom gewonnen ist.
- FIG 3: stellt einen Strombegrenzer dar, dessen Steuerspannung aus Spannungsfall am Halbleiterelement gewonnen wird.
- FIG 4: veranschaulicht einen Strombegrenzer, dessen Steuerspannung aus Laststrom und aus Spannungsfall am Halbleiterelement gewonnen ist.
- FIG 5: zeigt eine zweifache Weiterbildung des Strombegrenzers. Mit einem Strom-Spannungswandler zwischen zwei antiseriell verbundenen FETs wird die Steuerspannung aus dem Laststrom in besonders vorteilhafter Weise gewonnen. Weiter wird ein Schaltkontakt in Reihe zum Strombegrenzer eingesetzt.
- FIG 6: stellt einen Strombegrenzer mit Schaltkontakt dar, bei dem auf der Sekundärseite des Strom-Spannungswandlers antiseriell geschaltete Zenerdioden als spannungsbegrenzende Elemente in Brückenschaltung angeordnet sind. Ein Kondensator ist zwischen den Gleichspannungspotentialpunkten für die Steuerspannung auf der Sekundärseite eingeschaltet. Ein spannungsbegrenzendes Element auf der Primärseite erübrigt sich hierbei.
- FIG 7: veranschaulicht schematisch für einen Strombegrenzer nach Figur 6 den Einsatz einer Spannungsvervielfacher-Schaltung.
- FIG 8: gibt für die Ansteuerung aus Laststrom ein anderes Ausführungsbeispiel eines Strombegrenzers wieder, wonach der Strom-Spannungswandler als ein Zerhacker mit nachgeschaltetem Spannungsvervielfacher ausgeführt ist.
- FIG 9: veranschaulicht anhand der Darstellungsweise nach FIG 5 das Prinzip der Steuerspannungsaufbereitung aus Laststrom.
- FIG 10: veranschaulicht anhand der Darstellungsweise nach FIG 5 orientiert ein weiteres Grundprinzip, wonach die Steuerspannungsaufbereitung bei Einsatz eines Stromspannungswandlers durch eine Hilfsspannungsaufbereitung auf der Sekundärseite und eine Spannungsaufbereitung für die Gates aufgegliedert ist.
- FIG 11: stellt anhand der Darstellungsweise nach FIG 10 dar, wie eine zusätzliche externe Ansteuerung erfolgen kann.
- FIG 12: gibt eine alternative Ausführung für ein Befehlselement für eine zusätzliche externe Ansteuerung nach FIG 11 wieder.
- FIG 13: zeigt ein Ausführungsbeispiel für eine Weiterbildung des Strombegrenzers, wonach ein Übertrager als Stromspannungswandler mit dem Magnetsystem zur Betätigung des Schaltkontakts kombiniert ausgeführt ist.
- FIG 14: stellt oben das ausführliche Symbol für einen selbstsperrenden FET in Ausführung mit n-Kanal und darunter das hier in der Anmeldung entsprechende verkürzte Symbol dar.
- FIG 15: gibt ein Diagramm wieder, anhand dessen die Funktionsweise des Strombegrenzers veranschaulicht werden soll.
- FIG 16: stellt ein Magnetsystem für den Strombegrenzer dar, dessen Arbeitsluftspalt durch ein Hilfsjoch überbrückt ist, das derart bemessen ist, daß es in magne-tische Sättigung bereits bei Strömen geht, die klei-ner als der gewünschte Ansprechstrom für die Magnetanker sind.

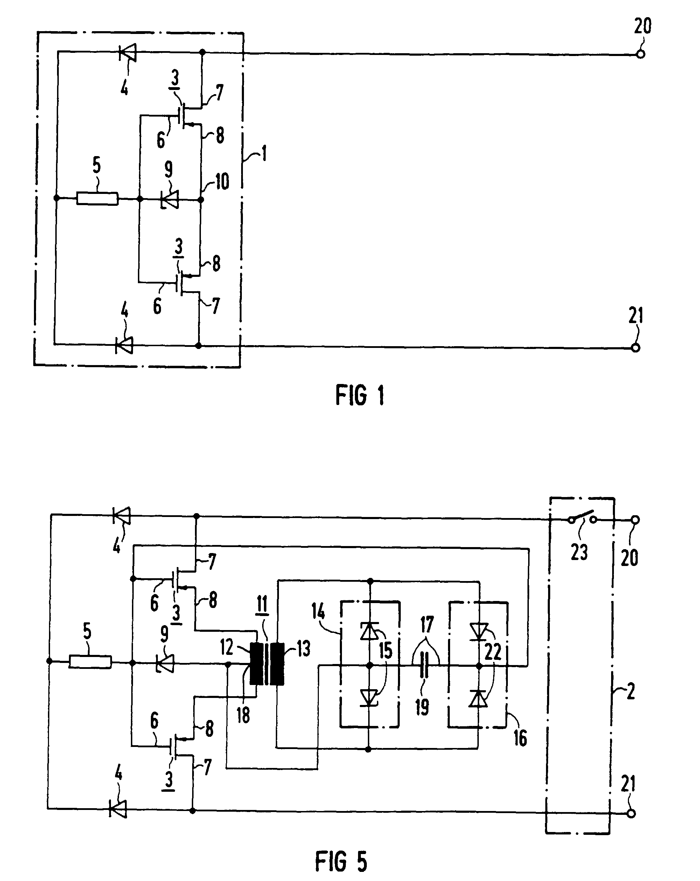

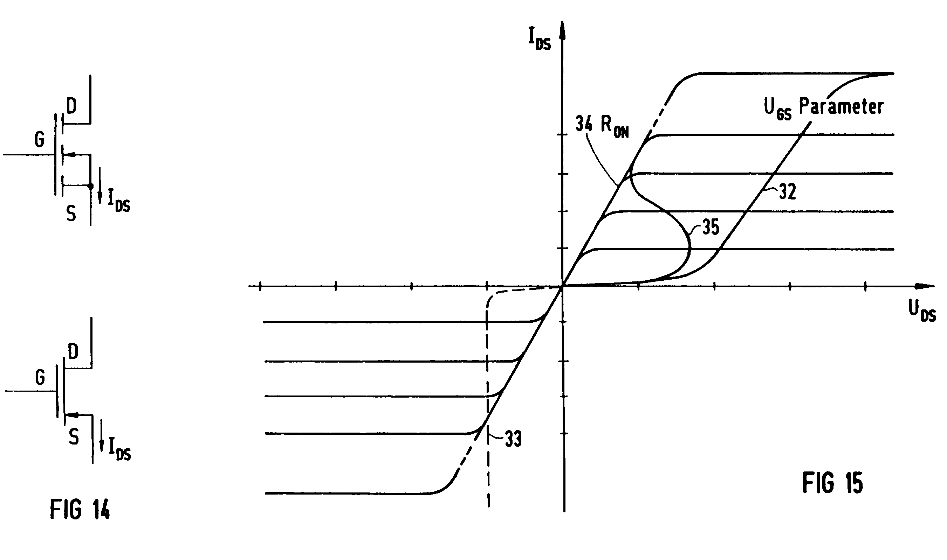

Das Halbleiterelement 1 nach FIG 1 arbeitet im Ausführungsbeispiel mit Feldeffekttransistoren 3, nachstehend FETs genannt. Im Ausführungsbeispiel können die FETs 3 entsprechend der oberen Darstellung in FIG 14 als solche des Anreicherungstyps (Enhancement) verstanden werden, die selbstsperrend sind und beispielsweise einen n-Kanal aufweisen. In der unteren Darstellung nach FIG 14 ist das hier benutzte verkürzte Symbol wiedergegeben. In FIG 1 ist ein Strombegrenzer für Wechselspannung dargestellt, der bei zwei zu schaltenden Polaritäten mit zwei antiseriell geschalteten FETs 3 arbeitet. Zur Ansteuerung des Halbleiterelements, bzw. der FETs, wird die erforderliche Steuerspannung aus Spannungsfall dadurch gewonnen, daß am FET jeweils an seinem Drain-Anschluß 7 eine Serienschaltung aus einem Ventil 4, z.B. eine Diode,und einem Widerstand 5 angeschlossen ist, die andererseits mit dem Gate-Anschluß 6 des FET 3 verbunden ist. Bei Wechselspannung und zwei antiseriell geschalteten FETs ist also an den Drain-Anschlüssen 7 jeweils über ein Ventil 4 und über einen Widerstand 5 eine Verbindung zu den Gate-Anschlüssen 6 hergestellt. Die Source-Anschlüsse 8 der FETs 3 sind miteinander verbunden.

Wenn nur ein Potential zu schalten ist, genügt anhand von FIG 1 orientiert der obere oder untere FET 3 in Verbindung mit dem zugeordneten Ventil 4 und dem Widerstand 5. Der Source-Anschluß 8 kann dann gegen Erde geführt sein.

Im Ausführungsbeispiel nach FIG 1 ist bei zwei antiseriell verbundenen FETs 3 als spannungsbegrenzendes Element 9 zwischen den Gate-Anschlüssen 6 und der Verbindung 10 der Source-Anschlüsse 8 der antiseriell verbundenen FETs 3 eine Zenerdiode eingeschaltet. Die Verbindung 10 führt den Laststrom.

Die Gate-Spannung der antiseriell verbundenen FETs 3 wird also über die Ventile 4 und über den Widerstand 5 gewonnen. Durch das spannungsbegrenzende Element 9 wird die Gate-Spannung begrenzt und damit ein maximal fließender Kurzschlußstrom.

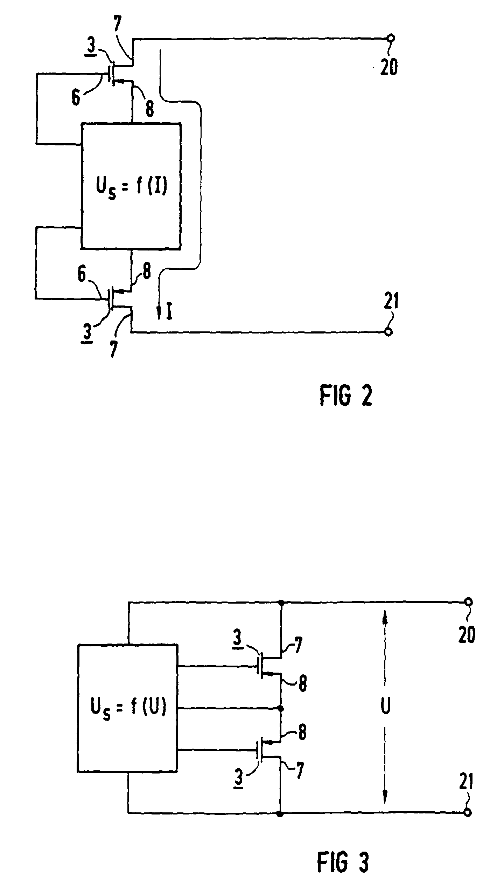

In FIG 2 ist veranschaulicht, wie die Steuerspannung U_{S} als Funktion des Laststroms I, U_{S}= f(I) gewonnen wird. In FIG 3 ist veranschaulicht, daß die Steuerspannung U_{S} als Funktion des Spannungsfalls U am Halbleiterelement erzielt werden kann, U_{S=} f(U). In FIG 4 ist veranschaulicht, wie die Steuerspannung U_{S} als Funktion des Laststroms und als Funktion des Spannungsfalls am Halbleiterelement zu erzielen ist: U_{S} = f(I) und U_{S} = f(U).

Bei der Weiterbildung nach FIG 5 ist zum Strombegrenzer ein mechanischer Schaltkontakt 2 in Reihe geschaltet. Der Strombegrenzer arbeitet mit zwei antiseriell verbundenen FETs, die mit ihren Source-Anschlüssen über einen Strom-spannungswandler 11 über dessen Primärwicklung 12 miteinander verbunden sind. Wesentlich ist hierbei weiter, daß am Strom-Spannungswandler 11 an seiner Sekundärseite, bzw. an seiner Sekundärwicklung 13 ein in beiden Polaritätsrichtungen spannungsbegrenzendes Element 14, insbesondere zwei antiseriell geschaltete Zenerdioden 15, angeschlossen ist. Die sekundärseitig angeschlossenen Zenerdioden 15 begrenzen die Spannung auf der Sekundärseite, wodurch auf der Primärseite infolge des Übersetzungsverhältnisses des Strom-Spannungswandlers 11 nur noch ein Spannungsfall von einigen zehn Millivolt auftritt. Auf der Primärseite auch durch die FETs 3 fließender Laststrom wird somit durch die verlustarme Begrenzung der Spannung auf der Sekundärseite durch den Strom-Spannungswandler begrenzt. Diese Wirkung steht im Zusammenspiel mit der halbleitertechnisch bedingten Begrenzung durch die besondere Ansteuerung der FETs 3. Andererseits ermöglicht das Übersetzungsverhältnis des Strom-Spannungswandlers 11 eine verhältnismäßig hohe Spannung als Gate-Source-Spannung auf die Primärseite zu führen, wodurch der ON-Widerstand verkleinert wird. R_{ON} erhält man bei großen Gate-Source-Spannungen. Die Wirkung im einzelnen soll später anhand von FIG 15 erläutert werden.

Beim Ausführungsbeispiel nach FIG 5 ist am Strom-Spannungswandler 11 an seiner Sekundärseite weiter eine Gleichrichterschaltung 16 angeschlossen, die zum einen mit dem Gate-Anschluß 6 der FETs 3 und zum anderen über eine Mittelanzapfung 18 der Primärwicklung 12 angeschlossen ist. Im Ausführungsbeispiel erfüllt ein Kondensator 19 als Speicherkondensator eine Doppelfunktion:
Zum einen trennt er die Gleichspannungspotentialpunkte 17 für die Steuerspannung und zum anderen stellt er sicher, daß im Strom-Spannungskennfeld des Halbleiterelements 1 mit den antiseriell geschalteten FETs 3 nicht jeweils ein Hochlaufen zum ON-Widerstand zwischen den parameterbedingten Kennlinien für die Gate-Source-Spannung im ersten und dritten Quadranten erforderlich ist, sondern daß auch bei Wechselspannung zwischen dem ersten und dem dritten am ON-Widerstand gearbeitet werden kann. Dies soll noch anhand von FIG 15 erläutert werden. In dieser zweiten Funktion dient der Kondensator 19 im Ausführungsbeispiel nach FIG 6. Dort sind die Gleichspannungspotentialpunkte 17 der Gleichrichterschaltung 16 auch ohne den Kondensator 19 bereitgestellt.

Beim Strombegrenzer nach FIG 5 wird der Strom-Spannungswandler 11 nicht wie üblich mit einem Widerstand abgeschlosssen, sondern durch die Zenerdioden 15 des spannungsbegrenzenden Elements 14. Durch den Abgriff der Gleichspannungspotentialpunkte 17 wird auf die Primärseite des Wandlers eine Gate-Hilfsspannung geführt, welche die Hilfsspannungserzeugung auf der Primärseite, wie sie zu FIG 1 erläutert worden ist, ergänzt bzw. ersetzt. Auf der Sekundärseite des Strom-Spannungswandlers 11 wird beispielsweise bei einer Zenerspannung von etwa 9,1 V und einer Flußspannung von etwa 0,9 V an den Zenerdioden 15 in einer Richtung eine Spannung in der Summe von etwa 10 V erreicht. Wenn also in der Primärwicklung 12 ein ausreichend großer Strom fließt, um den induktiven Widerstand zu überwinden, stellt sich auf der Primärseite infolge der sekundärseitigen 10 V eine Spannung entsprechend dem Übersetzungsverhältnis des Strom-Spannungswandlers 11 ein. Beispielsweise bei einem Übersetzungsverhältnis von 1 zu 1000 tritt also an der Primärwicklung 12 eine Spannung von lediglich 10 mV auf.

Die Schaltung nach FIG 5 funktioniert im einzelnen wie folgt:

Wenn an den Anschlußklemmen 20 und 21 des Selbstschalters eine Spannung beispielsweise infolge eines eingeschalteten Verbrauchers anliegt, fließt über die Ventile 4, bzw. die Dioden, ein Strom je nach Polarität der Wechselspannung, und es liegt infolge des Spannungsfalls am Widerstand 5 hinsichtlich der positiven Klemmenspannung bei 20 ein vermindert positives Potential an den Gate-Anschlüssen 6 an, so daß an den FETs 3 eine öffnende Gate-Source-Spannung anliegt und die Drain-Source-Strecken in den ON-Zustand gebracht werden. Der durch die Primärwicklung 12 des Strom-Spannungswandlers 11 fließende Strom erzeugt an der hochohmigen Sekundärwicklung eine Spannung, die bei Erreichen der Zenerspannung der oberen oder der unteren Zenerdiode 15 auf die Zenerspannung zuzüglich der Flußspannung der anderen Zenerdiode begrenzt wird, und zwar in beiden der Wechselspannung zugeordneten Stromflußrichtungen. An der Sekundärwicklung 13 entsteht hierbei eine nahezu rechteckige Wechselspannung, die über die Dioden 22 für die Gleichrichtung in der Schaltung eines Doppelweggleichrichters am Kondensator 19 eine Gleichspannung von der Größe der Zenerspannung jeder der Zenerdioden 15 erzeugt. Diese Gleichspannung wird den beiden Gate-Source-Strecken der FETs 3 zugeführt, wodurch diese im ON-Zustand gehalten werden, ohne weiter einen Spannungsfall am Widerstand 5 zu benötigen. Mit anderen Worten: Durch den Widerstand 5 fließt dann kein Strom mehr.

Im Ausführungsbeispiel nach FIG 6 ist als spannungsbegrenzendes Element 14 eine Brückenschaltung aus vier Zenerdioden 15 ausgebildet. Bei dieser Schaltung erübrigt sich ein strombegrenzendes Element 9 auf der Primärseite des Strom-Spannungswandlers 11. In Reihe ist wieder ein Schaltkontakt 23 angeordnet.

Die Amplituden der Wechselspannung in der Sekundärwicklung 13 des Stromspannungswandlers 11 können kleiner gehalten werden, wenn eine Spannungsvervielfacher-Schaltung 24 dem spannungsbegrenzenden Element 14 nachgeschaltet wird, wie es in FIG 7 veranschaulicht ist.

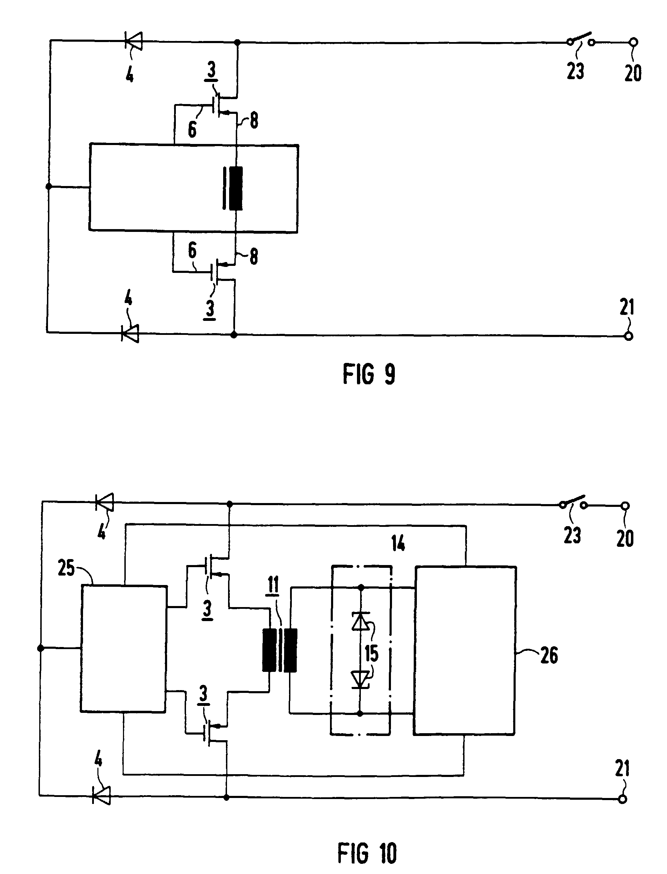

Zur Ansteuerung aus Laststrom kann der Stromspannungswandler nach FIG 8 als ein Zerhacker 39 mit nachgeschalteter Spannungsvervielfacher-Schaltung 24 ausgeführt sein. Am Zerhacker 39 liegt die an einem Widerstand 55 bei Laststrom auftretende Spannung an. Zur Begrenzung des Spannungsfalls und um die Verlustleistung zu minimieren, ist es vorteilhaft, ein spannungsbegrenzendes Mittel 40 vorzusehen. Im Ausführungsbeispiel können das zwei antiparalell geschaltete Dioden sein, die den Spannungsfall am Widerstand 5 auf den Durchlaßwiderstand der Dioden begrenzen.

In FIG 9 ist die Erzeugung der Steuerspannung zwischen den Gate-Anschlüssen 6 und den Sorce-Anschlüssen 8 der Feldeffekttransistoren 3 schematisch wiedergegebem. Die Erzeugung der Steuerspannung kann aufgeteilt werden auf eine Steuerspannungserzeugung 25 im Anlauffall und auf eine Hilfsspannungserzeugung 26, wie es im einzelnen anhand von FIG 5 erläutert worden ist.

In FIG 10 ist schematisch der Aufbau eines Strombegrenzers mit Steuerspannungsversorgung 25 und Hilfsspannungsversorgung 26 veranschaulicht. Die Steuerspannungsversorgung 25 kann als Anlaufschaltung ausgeführt sein, so daß die Steuerspannung im Arbeitsbetrieb dann von der Hilfsspannungsversorgung 26 übernommen wird.

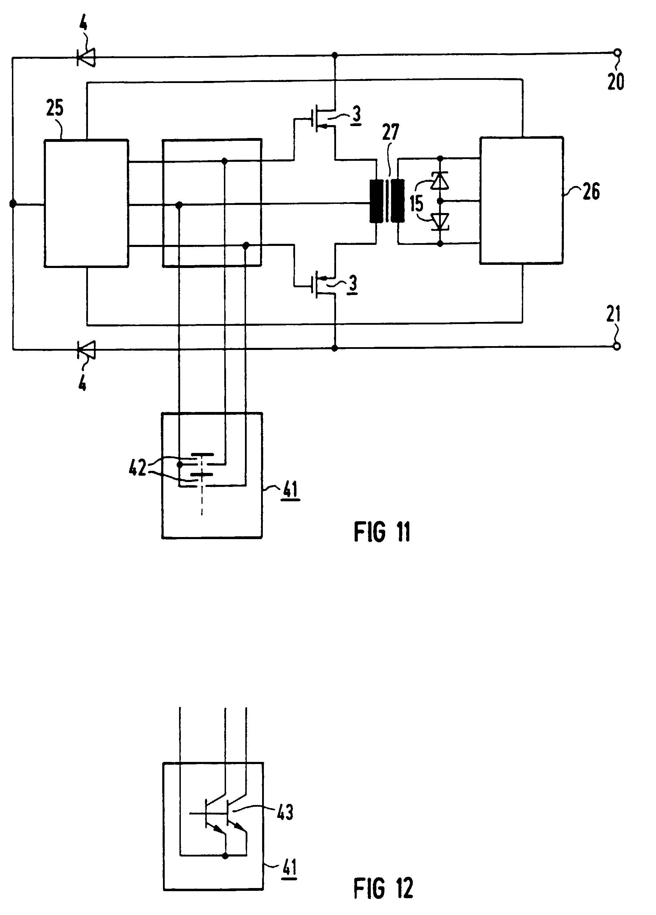

Um das Halbleiterelement zusätzlich extern ansteuern zu können, kann man eine externe Ansteuerungseinrichtung 41 nach FIG 11 vorsehen. Wenn Betätigungskontakte 42 geschlossen werden, wird die Gate-Source-Spannung kurzgeschlossen, so daß ein selbstsperrender FET in den Sperrzustand übergeht.

Die externe Ansteuereinrichtung 41 kann auch mit Halbleiterkontakten 43 nach FIG 12 arbeiten.

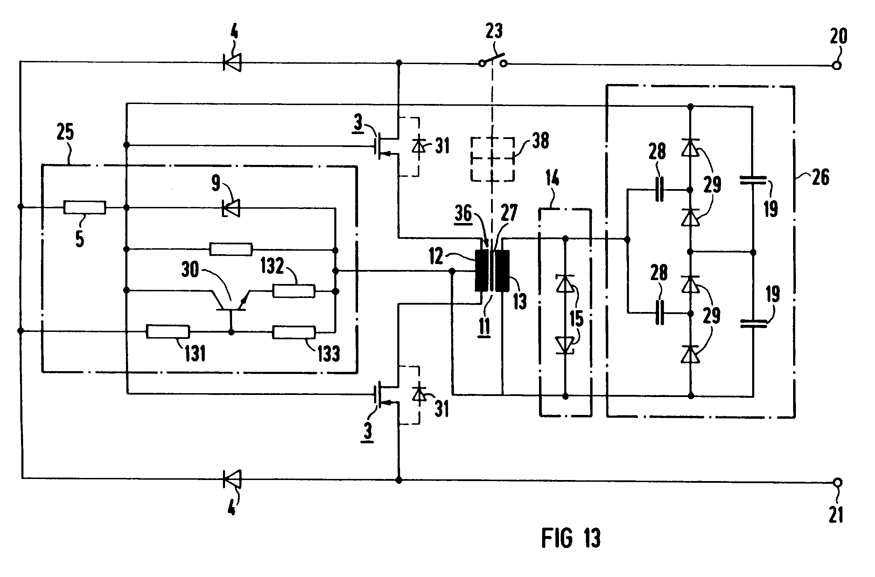

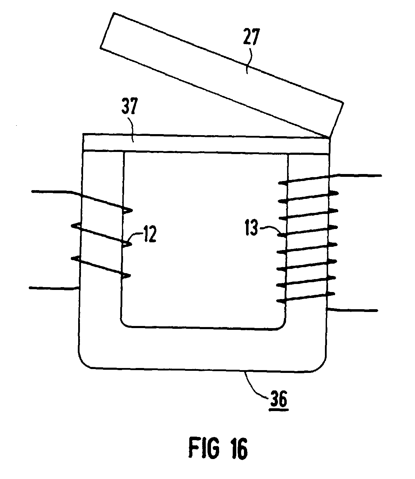

In FIG 13 ist zum einen eine vorteilhafte Ausgestaltung der Anordnung nach FIG 10 veranschaulicht, wobei die Hilfsspannungsaufbereitung als Spannungsvervielfacher-Schaltung ausgeführt ist, und zum anderen ist eine Weiterbildung wiedergegeben, wonach die niederohmige Primärwicklung mit einem Anker 27 in Wirkverbindung steht, der mit dem Schaltkontakt 23 in Eingriffverbindung zu bringen ist. Eine derartige Ausführung ist besonders kostengünstig, da der Strom-Spannungswandler 11 und das Magnetsystem 36, welches über den Anker 27 den Schaltkontakt öffnet, baulich und funktionell zusammengefaßt werden. Zusätzlich kann ein Kraftspeicher 38 nach Art eines Schaltschlosses vorgesehen werden. Auf die niederohmige, den Anker treibende Primärwicklung 12 kann hierbei eine hochohmige Wicklung mit vielen Windungen als Sekundärwicklung 13 aufgebracht werden. Hierbei kann ein kleines Hilfsjoch 37, man vergleiche FIG 16, den magnetischen Kreis für die Funktion des Strom-Spannungswandlers 11 schließen. Dieses Hilfsjoch ist vorteilhaft derart bemessen, daß es bereits bei vergleichsweise kleinen Strömen in Sättigung geht, so daß die Funktion des auf den Schaltkontakt 23 einwirkenden Ankers 27 praktisch nicht beeinflußt wird. Die niederohmige Primärwicklung 12 kann aus wenigen Windungen, beispielsweise zwei bis vier Windungen, bestehen und ein günstiger Spannungsbereich für die Hiflsspannungsaufbereitung kann auf der Sekundärseite bis zu einem gewünschten Spannungswert durch die Spannungsvervielfacher-Schaltung angehoben werden. Die Spannungsvervielfacher-Schaltung besteht aus den Bauelementen: Kondensatoren 28 und 19, wobei die Kondensatoren 19 zugleich die Gleichspannung für die Ansteuerung der FETs 3 bereitstellen, sowie den Dioden 29, die in der wiedergegebenen Schaltung zugleich die Gleichrichtung besorgen.

Die Steuerungsversorgung 25 nach FIG 13 zeigt eine Möglichkeit, eine "Fall-Back"-Kennlinie zu erzeugen. Die wesentlichen Bauteile hierfür sind der Transistor 30 und die Widerstände 31, 32 und 33. Dieses Schaltungsteil arbeitet folgendermaßen:
Wenn infolge erhöhten Stromes, wie er beispielsweise bei Kurzschluß auftritt, die strombegrenzende Wirkung der FETs 3 einsetzt, steigt die Spannung an den Klemmen 20 und 21 an. Diese Spannung erscheint am Brückengleichrichter, der durch die Dioden der Ventile 4 und die Body-Dioden, auch als Inversdiode bezeichnet, der FETs 3 gebildet wird. Als Body-Diode versteht man bekanntlich die jeder Grenzschicht, insbesondere einem MOS-FET eigene innere Diodenwirung des pn-Übergangs von Source nach Drain. Die Body-Dioden sind mit 31 bezeichnet veranschaulicht. Die am geschilderten Brückengleichrichter anliegende Spannung liegt auch an der Serienschaltung der Widerstände 131 und 133 an, wodurch am Widerstand 133 ein Spannungsfall auftritt, der den Transistor 30 in einen leitenden Zustand aufsteuert. Durch die Größe des Widerstands 132 kann eine Gate-Source-Spannung eingeschaltet werden, die bei steigender Spannung an den Klemmen 20 und 21 immer kleiner wird und damit einen Laststrom durch die FETs 3 reduziert. Das wiedergegebene Ausführungsbeispiel zeigt nur eine Möglichkeit, nach den erfindungsgemäßen Prinzipien eine Fall-Back-Kennlinie zu erzeugen. Bekanntlich kann mit einem Operationsverstärker jede gewünschte Kennlinie erzeugt werden.

In FIG 14 ist in der oberen Darstellung das vollständige Symbol für einen FET wiedergegeben und in der unteren Darstellung das verkürzte Symbol, wie es in der vorliegenden Beschreibung verwendet wird. Eingetragen sind die üblichen Abkürzungen für Drain, Gate und Source, sowie die positive Richtung des Drain-Source-Stromes. Die Darstellung nach FIG 14 zeigt einen FET des Enhancement-Typs, also einen selbstsperrenden FET, der einen n-Kanal aufweist. Insbesondere ist die Darstellungsweise nach FIG 14 als MOSFET zu verstehen. Verständlicherweise können die wiedergegebenen Schaltungen nachg den Figuren 1 bis 13 auch durch andere entsprechende Bauelemente, insbesondere durch andere FETs realisiert werden. So ist bei Verwendung von p-Kanal-FETs lediglich die übliche Polaritätsumkehr vorzunehmen. Wesentlich ist, daß Kennlinien realisiert werden können, wie sie in FIG 15 dargestellt sind, daß also für Gleichspannung unabhängig von der Spannung ein maximaler Strom einstellbar ist und daß für Wechselspannung derartige Verhältnisse in zwei diagonal gegenüberliegenden Quadranten herschen. Die hier beispielhaft anhand von bestimmten FETs wiedergegebenen Schaltungen sind in diesem allgemeinen Sinn zu sehen.

Anhand von FIG 15 sollen Wirkungsprinzipien beim Strombegrenzer erläutert werden:

FIG 15 gibt ein Diagramm wieder, wobei auf der Ordinate der Drain-Source-Strom I_{DS} und auf der Abszisse die Drain-Source-Spannung U_{DS} abgetragen ist. Ein FET der hier geschilderten Art, wie er zu FIG 14 erläutert ist, weist von Haus aus eine Kennlinie 32 auf, die bei negativer Drain-Source-Spannung in die Kennlinie 33 der Body-Diode übergeht. Die horizontalen Kennlinien ergeben sich bei einem Parameter Gate-Source-Spannung und begrenzen den Drain-Source-Strom bei entsprechender Beschaltung. Bei hohen Gate-Source-Spannungen wird ein steiler ON-Widerstand, R_{ON}, erreicht. Bei antiserieller Schaltung von FETs im Falle von Wechselspannung wird eine symmetrische Arbeitsweise zwischen dem ersten und dritten Quadranten erzielt, wobei die Kennlinie 33 der Body-Diode nicht mehr zum Tragen kommt. Mit einer Schaltung mit einem Strom-Spannungswandler der geschilderten Beschaltung erreicht man ein Hochlaufen über die Kennlinie 35, die in die Gerade für den physikalisch vorgegebenen ON-Widerstand des verwendeten FETs einmündet.

Einen Hochlauf für jede Polaritatsrichtung einer Wechselspannung vermeidet man in einer antiseriellen Anordnung von FETs, wenn ein Kondensator 19 als Speicherkondensator in der beschriebenen Weise eingesetzt wird. Die strombegrenzende Wirkung der antiseriell geschalteten FETs entfaltet sich dann zwischen einer gewählten horizontalen Kennlinie mit der entsprechende Gate-Source-Spannung als Parameter im ersten und dritten Quadranten in Verbindung mit einem Übergang der Kennlinie 34 für den ON-Widerstand. Hierbei wirkt sich die Fläche zwischen der Kennlinie 32 und einer im ersten Quadranten links liegenden gewählten Kennlinie als Verlusteinsparung aus, wie aus dem Produkt des Drain-Source-Stroms und der Drain-Source-Spannung veranschaulicht zu ersehen ist. Die Möglichkeiten der geschilderten Prinzipien werden durch Einsatz von FETs aus Siliziumkarbid weiter in erheblicher Weise gefördert. Das Halbleiterelement 1, das mit der Schalteinrichtung in Reihe geschaltet ist, kann in den verschiedenen Ausführungsarten jeweils insgesamt oder teilweise als integrierter Schaltkreis realisiert werden. Der Strombegrenzer kann auch ohne Schalteinrichtung vielfältige Anwendungen finden.

In FIG 16 ist ein Magnetsystem 36 mit Primärwicklung 12 und Sekundärwicklung 13 veranschaulicht, das ein Hilfsjoch 37 und einen Anker 27 aufweist. Ein derartiges Magnetsystem ist für die bauliche Kombination eines Strombegrenzers mit einer Schalteinrichtung vorteilhaft, was bereits erläutert worden ist.

## Patentansprüche

1. Strombegrenzer zum Begrenzen von Überströmen mittels eines Halbleiterelements (1) mit mindestens einem steuerbaren Halbleiter (3) mit Elektronenquelle (Source), Elektronensammler (Drain) und den Elektronenfluß steuernder Steuerelektrode (Gate), der Kennlinien nach Art eines Feldeffekttransistors (FET;3) aufweist, wobei der Laststrom das Halbleiterelement durchfließt und wobei gegebenenfalls bei Wechselspannung zwei FETs antiseriell geschaltet sind, und wobei Mittel vorgesehen sind zur internen Gewinnung der zur Ansteuerung des Halbleiterelements (1) erforderlichen Steuerspannung aus zumindest einem Teil des Spannungsabfalls am Halbleiterelement und/oder zumindest einem Teil des das Halbleiterelement (1) durchfließenden Laststroms.

2. Strombegrenzer nach Anspruch 1, **dadurch gekennzeichnet,** daß das Mittel zur Ansteuerung aus Spannungsfall jeweils eine an Drain (7) und Gate (6) des Halbleiters (3) angeschlossene Ansteuerschaltung ist.

3. Strombegrenzer nach Anspruch 1, **dadurch gekennzeichnet,** daß das Mittel zur Ansteuerung aus Laststrom jeweils ein im Laststrom liegender Strom-Spannungswandler (11) ist.

4. Strombegrenzer nach Anspruch 2, **dadurch gekennzeichnet,** daß die Ansteuerschaltung bei Gleichspannung aus einem Widerstand (5) besteht, der zwischen Drain-Anschluß (7) und-Gate-Anschluß (6) angeschlossen ist, und daß gegebenenfalls bei Wechselspannung die Drain-Anschlüsse (7) der beiden antiseriell geschalteten FETs über jeweils ein Ventil (4) und über einen Widerstand (5) mit den Gate-Anschlüssen (6) verbunden sind.

5. Strombegrenzer nach Anspruch 2, **dadurch gekennzeichnet,** daß die Ansteuerschaltung bei Gleichspannung aus einer Konstantstromquelle besteht, die zwischen Drain-Anschluß (7) und Gate-Anschluß (6) angeschlossen ist, und daß gegebenenfalls bei Wechselspannung die Drain-Anschlüsse (7) der beiden antiseriell geschalteten FETs über jeweils ein Ventil (4) und über eine Konstantstromquelle mit den Gate-Anschlüssen (6) verbunden sind.

6. Strombegrenzer nach Anspruch 3, **dadurch gekennzeichnet,** daß als Strom-Spannungswandler ein Übertrager dient, an dessen Sekundärwicklung (13) ein in beiden Polaritätsrichtung spannungsbegrenzendes Element (14), insbesondere zwei antiseriell geschaltete Zenerdioden, angeschlossen ist, bzw. sind, dessen Ausgänge über eine Gleichrichterschaltung (16) mit den Gate-Anschlüssen (6) verbunden sind.

7. Strombegrenzer nach Anspruch 6, **dadurch gekennzeichnet,** daß am Übertrager an seiner Sekundärwicklung (13) eine Gleichrichterschaltung (16) angeschlossen ist, deren Gleichspannungspotentialpunkte (17) zum einen mit den Gate-Anschlüssen (6) der FETs (3) und zum anderen über eine Mittelanzapfung (18) der Primärwicklung (12) angeschlossen ist und daß ein Kondensator (19) zwischen den Gleichspannungspotentialpunkten (17) für die Steuerspannung eingeschaltet ist.

8. Strombegrenzer nach Anspruch 3, **dadurch gekennzeichnet,** daß am Übertrager an seiner Sekundärwicklung (13) ein Brückengleichrichter aus Zenerdioden angeordnet ist, dessen Gleichspannungsausgänge mit den Gates verbunden sind.

9. Strombegrenzer nach Anspruch 6, **dadurch gekennzeichnet**, daß die Gleichrichterschaltung als Spannungsvervielfacherschaltung (24) ausgebildet ist.

10. Strombegrenzer nach Anspruch 3, **dadurch gekennzeichnet,** daß der Strom-Spannungswandler ein Zerhacker mit nachgeschaltetem Spannungsvervielfacher ist.

11. Strombegrenzer nach einem der vorhergehenden Ansprüche, **dadurch gekennzeichnet,** daß die Halbleiter (3) aus Siliziumkarbid (SiC) gefertigt sind.

12. Strombegrenzer nach Anspruch 1, 2 oder 3, **dadurch gekennzeichnet,** daß zwischen dem bzw. den Gate-Anschlüssen (6) und dem Source-Anschluß (8) bzw. der Verbindung (10) der beiden Source-Anschlüsse ein Element (9) mit der Wirkung einer strombegrenzenden Zenerdiode eingeschaltet ist, das so dimensioniert ist, daß die Gate-Spannung des Halbleiters bzw. der Halbleiter auf einen Wert eingestellt ist, bei dem sich die gewünschte Begrenzung des Überlaststromes einstellt.

13. Strombegrenzer nach einem der vorhergehenden Ansprüche, **dadurch gekennzeichnet,** daß am Halbleiterelement (1) eine Ansteuereinrichtung zur zusätzlichen externen Ansteuerung ausgebildet ist.

14. Strombegrenzer nach Anspruch 13, **dadurch gekennzeichnet,** daß die Ansteuereinrichtung dafür ausgelegt ist, eine das Halbleiterelement (1) sperrende Spannung zu generieren bei Erhalt eines vorgesehenen Eingangssignals.

15. Strombegrenzer nach einem der vorhergehenden Ansprüche, **dadurch gekennzeichnet,** daß in Reihe zum Halbleiterelement (1) zumindest ein mechanischer Schaltkontakt (23) geschaltet ist.

16. Strombegrenzer nach Anspruch 15, **dadurch gekennzeichnet,** daß der Schaltkontakt (23) direkt oder indirekt über einen Kraftspeicher (38) in Eingriffverbindung mit einem Magnetsystem (36) steht.

17. Strombegrenzer nach Anspruch 16, **dadurch gekennzeichnet,** daß das Magnetsystem (36) eine zur Sekundärwicklung (13) vergleichsweise niederohmige Primärwicklung (12) aufweist und einerseits den Übertrager zur Gewinnung einer Steuerspannung aus Laststrom bildet und andererseits mit seiner niederohmigen Primärwicklung (12) zugleich die Erregerwicklung für das jeweilige Magnetsystem bildet, dessen Anker (27) in Wirkverbindung mit dem Schaltkontakt (23) steht.

18. Strombegrenzer nach Anspruch 17, **dadurch gekennzeichnet**, daß beim Magnetsystem (36) sein Arbeitsluftspalt durch ein Hilfsjoch (37) überbrückt ist, das derart bemessen ist, daß es in magnetische Sättigung bereits bei Strömen geht, die kleiner als der gewünschte Ansprechstrom für den Magnetanker (27) sind.

19. Strombegrenzer nach einem der Ansprüche 15 bis 18, **dadurch gekennzeichnet,** daß das Halbleiterelement (1) in einem Selbstschalter, wie Leistungsschalter, Leitungsschutzschalter oder Motorschutzschalter oder dergleichen als strombegrenzendes Teil mit der Funktion eines Limiters eingesetzt ist.

20. Strombegrenzer nach Anspruch 15, **dadurch gekennzeichnet**, daß das Halbleiterelement (1) und der mechanische Schaltkontakt (23) jeweils Teil räumlich gesonderter Schalteinrichtungen sind.

## Claims

1. Current limiter for limiting overload currents by means of a semiconductor element (1) with at least one controllable semiconductor (3) with electron source (source), electron acceptor (drain) and control electrode (gate) controlling the electron flow, which current limiter has characteristic curves typical of a field-effect transistor (FET;3), there being, if appropriate, in the case of alternating voltage, two FETs connected antiserially, and there being means provided for internally obtaining the control voltage required for driving the semiconductor element (1) from at least part of the voltage drop over the semiconductor element.

2. Current limiter according to Claim 1, characterized in that the means for driving from the voltage drop is respectively a drive circuit connected to the drain (7) and the gate (6) of the semiconductor (3).

3. Current limiter according to Claim 1, characterized in that the means for driving from the load current is respectively a current-to-voltage converter (11) situated in the load current.

4. Current limiter according to Claim 2, characterized in that the drive circuit in the case of direct voltage comprises a resistor (5), which is connected between the drain terminal (7) and the gate terminal (6), and in that, if appropriate, in the case of alternating voltage, the drain terminals (7) of the two antiserially connected FETs are connected to the gate terminals (6) via respectively a valve (4) and via a resistor (5).

5. Current limiter according to Claim 2, characterized in that the drive circuit in the case of direct voltage comprises a constant-current source which is connected between the drain terminal (7) and the gate terminal (6)
and in that, if appropriate, in the case of alternating voltage, the drain terminals (7) of the two antiserially connected FETs are connected to the gate terminals (6) via respectively a valve (4) and via a constant-current source.

6. Current limiter according to Claim 3, characterized in that there serves as the current-to-voltage converter a transformer to whose secondary winding (13) there is, or are, connected an element (14) limiting the voltage in both directions of polarity, in particular two antiserially connected zener diodes, whose outputs are connected to the gate terminals (6) via a rectifier circuit (16).

7. Current limiter according to Claim 6, characterized in that there is connected to the transformer at its secondary winding (13) a rectifier circuit (16) whose direct-voltage potential points (17) are connected on the one hand to the gate terminals (6) of the FETs (3) and on the other hand via a central tap (18) of the primary winding (12) and in that a capacitor (19) is connected between the direct-voltage potential points (17) for the control voltage.

8. Current limiter according to Claim 3, characterized in that there is arranged on the transformer at its secondary winding (13) a bridge rectifier of zener diodes whose direct-voltage outputs are connected to the gates.

9. Current limiter according to Claim 6, characterized in that the rectifier circuit is designed as a voltage multiplier circuit (24).

10. Current limiter according to Claim 3, characterized in that the current-to-voltage converter is a chopper with a downstream voltage multiplier.

11. Current limiter according to one of the preceding claims, characterized in that the semiconductors (3) are made from silicon carbide (SiC).

12. Current limiter according to Claim 1, 2 or 3, characterized in that there is connected between the gate terminal or terminals (6) and the source terminal (8), or the connection (10) of the two source terminals, an element (9) with the effect of a current-limiting zener diode which is dimensioned such that the gate voltage-of the semiconductor or of the semiconductors is set to a value at which the desired limitation of the overload current occurs.

13. Current limiter according to one of the preceding claims, characterized in that there is formed on the semiconductor element (1) a drive device for additional external driving.

14. Current limiter according to Claim 13, characterized in that the drive device is designed for generating a voltage turning off the semiconductor element (1) when a predetermined input signal is received.

15. Current limiter according to one of the preceding claims, characterized in that at least one mechanical switching contact (23) is connected in series with the semiconductor element (1).

16. Current limiter according to Claim 15, characterized in that the switching contact (23) is in engaging connection with a magnetic system (36) directly or indirectly via an energy store (38).

17. Current limiter according to Claim 16, characterized in that the magnetic system (36) has a primary winding (12) of low impedance in comparison with the secondary winding (13) and on the one hand forms the transformer for obtaining a control voltage from the load current and on the other hand forms with its low-impedance primary winding (12) at the same time the excitation winding for the respective magnetic system whose armature (27) is in operative connection with the switching contact (23).

18. Current limiter according to Claim 17, characterized in that the working air gap of the magnetic system (36) is bridged by an auxiliary yoke (37) which is dimensioned in such a way that it already goes into magnetic saturation at currents which are less than the desired operating current for the magnet armature (27).

19. Current limiter according to one of Claims 15 to 18, characterized in that the semiconductor element (1) is used in an automatic circuit-breaker, such as a power switch, automatic cut-out or motor protection switch or the like, as a current-limiting part with the function of a limiter.

20. Current limiter according to Claim 15, characterized in that the semiconductor element (1) and the mechanical switching contact (23) are respectively part of physically separate switching devices.

## Revendications

1. Limiteur de courant pour la limitation de surintensité de courant au moyen d'un élément (1) à semi-conducteur comportant au moins un semi-conducteur (3) pouvant être commandé, comportant une source d'électrons (source), un collecteur d'électrons (drain) et une électrode de commande (grille) commandant le courant d'électrons, qui comporte des caractéristiques du genre d'un transistor à effet de champ (FET ; 3), le courant de charge traversant l'élément à semi-conducteur et deux transistors à effet de champ étant branchés de manière antisérielle éventuellement en cas de tension alternative, et des moyens étant prévus pour obtenir de manière interne la tension de commande nécessaire à la commande de l'élément (1) à semi-conducteur à partir d'au moins une partie de la chute de tension aux bornes de l'élément semi-conducteur et/ou à partir d'au moins une partie du courant de charge traversant l'élément (1) à semi-conducteur.

2. Limiteur de courant suivant la revendication 1, caractérisé en ce que le moyen de commande à partir d'une chute de tension est un circuit de commande connecté au drain (7) et à la grille (6) du semi-conducteur (3).

3. Limiteur de courant suivant la revendication 1, caractérisé en ce que le moyen de commande à partir du courant de charge est un convertisseur (11) courant-tension auquel est appliqué le courant de charge.

4. Limiteur de courant suivant la revendication 2, caractérisé en ce que le circuit de commande est constitué, en cas de tension continue, d'une résistance (5), qui est connectée entre la borne de drain (7) et la borne de grille (6) et les bornes (7) de drain des deux transistors à effet de champ branchés de manière antisérielle sont reliées éventuellement en cas de tension alternative par intermédiaire respectivement d'une vanne (4) et d'une résistance (5) aux bornes (6) de grille.

5. Limiteur de courant suivant la revendication 2, caractérisé en ce que le circuit de commande est constitué, en cas de tension continue, d'une source de courant constant, qui est connectée entre la borne (7) et la borne de grille (6), et les bornes de drain (7) des deux transistors à effet de champ branchés de manière antisérielle sont reliés, éventuellement en cas de tension alternative, par l'intermédiaire respectivement d'une vanne (4) et d'une source de courant constant aux bornes (6) de grille.

6. Limiteur de courant suivant la revendication 3, caractérisé en ce qu'un transformateur, à l'enroulement secondaire (13) duquel est connecté un élément (14) limitant la tension dans les deux sens de polarité, notamment deux diodes zéners branchées de manière antisérielle, dont les sorties sont reliées aux bornes de grille (6) par l'intermédiaire d'un circuit redresseur (16), sert de convertisseur courant-tension.

7. Limiteur de courant suivant la revendication 6, caractérisé qu'il est connecté à l'enroulement secondaire (13) du transformateur un circuit (16) redresseur, dont les points (17) de potentiel de tension continue sont connectés d'une part aux bornes de grille (6) des transistors à effet de champ (3) et d'autre part par l'intermédiaire d'une prise médiane (18) de l'enroulement primaire (12), et un condensateur (19) est branché entre les points (17) de potentiel de tension continue pour la tension de commande.

8. Limiteur de courant suivant la revendication 3, caractérisé en ce qu'un redresseur en pont de diodes Zener, dont les sorties de tension continue sont reliées aux grilles, est monté à l'enroulement secondaire (13) du transformateur.

9. Limiteur de courant suivant la revendication 6, caractérisé en ce que le circuit redresseur est sous forme de circuit (24) multiplicateur de tension.

10. Limiteur de courant suivant la revendication 3, caractérisé en ce que le convertisseur courant-tension est un hacheur en aval duquel est branché un multiplicateur de tension.

11. Limiteur de courant suivant l'une des revendications précédentes, caractérisé en ce que le semi-conducteur (3) est fabriqué en carbure de silicium (SiC).

12. Limiteur de courant suivant la revendication 1, 2 ou 3, caractérisé en ce qu'il est branché entre la ou les bornes (6) de grille et la borne de source (8) ou la liaison (10) des deux bornes de source un élément (9) ayant l'effet d'une diode Zener limitant le courant et dimensionné de telle sorte que la tension de grille du semi-conducteur ou des semi-conducteurs soit réglée à une valeur pour laquelle la limitation souhaitée du courant de surcharge s'établisse.

13. Limiteur de courant suivant l'une des revendications précédentes, caractérisé en ce qu'un circuit pour la commande supplémentaire externe est formé sur l'élément (1) à semi-conducteur.

14. Limiteur de courant suivant la revendication 13, caractérisé en ce que le dispositif de commande est conçu pour générer une tension qui bloque l'élément (1) à semi-conducteur, en cas de réception d'un signal d'entrée prévu.

15. Limiteur de courant suivant l'une des revendications précédentes, caractérisé en ce qu'au moins un contact (23) d'interruption mécanique est branché en série avec l'élément (1) à semi-conducteur.

16. Limiteur de courant suivant la revendication 15, caractérisé en ce que le contact (23) d'interruption est en prise avec un système (36) magnétique directement ou indirectement par l'intermédiaire d'un accumulateur (38) d'énergie.

17. Limiteur de courant suivant la revendication 16, caractérisé en ce que le système magnétique (36) comporte un enroulement primaire (12) basse impédance par rapport à l'enroulement secondaire (13) et d'une part forme le transformateur pour l'obtention d'une tension de commande à partir du courant de charge et forme d'autre part par son enroulement primaire (12) basse impédance en même temps l'enroulement d'excitation pour le système magnétique, dont l'armature (27) coopère avec le contact (23) d'interruption.

18. Limiteur de courant suivant la revendication 17, caractérisé en ce que l'entrefer de travail du système magnétique (36) est ponté par une culasse (37) auxiliaire, qui est telle qu'elle passe en saturation magnétique déjà pour des courants qui sont plus petits que le courant de réponse souhaité pour l'armature (27) magnétique.

19. Limiteur de courant selon l'une des revendications 15 à 18, caractérisé en ce que l'élément (1) à semi-conducteur est utilisé dans un interrupteur automatique, comme un disjoncteur, un disjoncteur de protection de ligne, ou un disjoncteur de protection de moteur ou similaire en tant que partie limitant le courant ayant la fonction d'un limiteur.

20. Limiteur de courant suivant la revendication 15, caractérisé en ce que l'élément (1) à semi-conducteur et le contact (23) d'interruption mécanique font chacun partie de dispositif d'interruption séparés dans l'espace.
